# EUROPEAN PATENT APPLICATION

(11) **EP 2 017 362 A1**
(43) Date of publication of application: **21.01.2009**
(21) Application number: 07254119.6
(22) Date of filing: 17.10.2007
(51) Int. Cl.: C22C 27/02, B22F 3/00, B32B 15/01, C23C 14/34, H01L 21/285

(54) **Brittle metall alloy sputtering targets and method of fabricating same**

(30) Priority: 02.07.2007 US 822065
(71) Applicant: Heraeus, Inc., Chandler AZ 85226 (US)
(72) Inventor: Yi, Wuwen, Tempe AZ 85284 (US); Kunkel, Bernd, Phoenix AZ 85048 (US); Derrington, Carl, Tempe AZ 85284 (US); Li, Shinhwa, Chandler AZ 85248 (US); Deodutt, Anand, Gilbert AZ 85233 (US)
(74) Representative: Driver, Virginia Rozanne

(57) **Abstract**

A method of fabricating a sputtering target assembly comprises steps of mixing/blending selected amounts of powders of at least one noble or near-noble Group VIII metal at least one Group IVB, VB, or VIB refractory metal; forming the mixed/blended powder into a green compact having increased density; forming a full density compact from the green compact; cutting a target plate slice from the full density compact; diffusion bonding a backing plate to a surface of the target plate slice to form a target/backing plate assembly; and machining the target/backing plate assembly to a selected final dimension. The disclosed method is particularly useful for fabricating large diameter Ru-Ta alloy targets utilized in semiconductor metallization processing.

## Description

### FIELD OF THE DISCLOSURE

The present disclosure relates generally to targets for use in sputter deposition processing and to a method for their fabrication. In particular, the present disclosure relates to targets comprised of brittle metal alloys of Group VIII metals and refractory metals from Groups IVB, VB, and VIB of the periodic table, especially targets comprised of Ru-Ta alloys.

### BACKGROUND OF THE DISCLOSURE

Copper (Cu) and Cu-based alloys are frequently utilized in the manufacture of integrated circuit semiconductor devices requiring complex metallization systems for "back-end of line" processing of the semiconductor wafers on which the devices are based, in view of their very low resistivities, relatively high resistance to electromigration, and low cost. While Cu and Cu-based alloys are currently preferred materials for forming electrical connections in advanced integrated circuits, they nevertheless incur several disadvantages which can render their use problematic.

Specifically, Cu and Cu-based alloys do not adhere well to oxide materials commonly utilized as inter-layer dielectrics (ILDs); they can diffuse into adjacent dielectric layers, with consequent loss of insulating properties and formation of undesired electrical pathways leading to shorting; and diffusion of oxygen atoms from adjacent dielectric layers into the Cu or Cu-based alloy layers can result in loss of conductivity. In order to mitigate at least some of these shortcomings of Cu-based metallization schemes, a Ta/TaN bi-layer is typically interposed between the oxide-based dielectric layers and the Cu-based metallization, the TaN serving as a barrier layer against diffusion and the Ta layer serving as an adhesion layer for the Cu-based metallization layer formed over it, typically by an electroplating process. In practice, a thin Cu or Cu-based seed layer is required to be formed over the Ta adhesion layer prior to electroplating, as by a physical vapor deposition (PVD) process, such as sputtering. However, attainment of Cu seed layers having good continuity is frequently difficult in view of the complex topography of the device being metallized.

Ruthenium (Ru) has been suggested as a possible replacement for both the Ta adhesion layer and the Cu seed layer conventionally utilized in Cu-based metallization processing. The use of Ru offers several potential advantages vis-à-vis the conventional metallization methodology, in view of several of its favorable properties/characteristics. Specifically, Ru: (1) does not readily oxidize, and if oxidation occurs, the oxide is electrically conductive, whereby conductivity loss upon oxidation is mitigated; and (2) it adheres to both TaN and Cu, thereby offering the possibility of its use as both seed and electroplating layers.

Sputter deposition is an attractive technique for forming thin films with good surface coverage required in "back-end of line" metallization of semiconductor integrated circuit devices. Disadvantageously, however, the brittle nature of many metal alloys potentially useful in metallization processing, particularly Ru and its alloys, have impeded development of alloy-based sputtering targets, particularly large diameter targets necessary for performing metallization processing of currently employed large diameter semiconductor wafers in a production-scale, cost-effective manner.

In view of the foregoing, there exists a clear need for such brittle metal alloy-based sputtering targets, especially Ru alloy-based sputtering targets, and fabrication methodology therefor, particularly large diameter targets suitable for use in performing metallization processing of large diameter semiconductor wafers in production-scale, cost-effective manner. In addition, there exists a general need for sputtering targets comprising alloys of brittle metals, i.e., precious and noble Group VIII metals and refractory metals from Groups IVB, VB, and VIB of the periodic table, such as RuTa alloys, for use, *inter alia,* in semiconductor device manufacturing processing.

### SUMMARY OF THE DISCLOSURE

An advantage of the present disclosure is an improved method of fabricating a brittle metal alloy sputtering target.

Another advantage of the present disclosure is an improved method of fabricating a brittle Ru-Ta alloy sputtering target.

Further advantages of the present disclosure are improved brittle metal alloy and Ru-Ta alloy sputtering targets fabricated according to the improved method of the present disclosure.

Still other advantages of the present disclosure are improved brittle metal alloy and Ru-Ta alloy sputtering targets.

Additional advantages and features of the present disclosure will be set forth in the disclosure which follows and in part will become apparent to those having ordinary skill in the art upon examination of the following or may be learned from the practice of the present disclosure. The advantages may be realized and obtained as particularly pointed out in the appended claims.

According to an aspect of the present disclosure, the foregoing and other advantages are achieved in part by an improved method of fabricating a method of fabricating a metal alloy sputtering target assembly, comprising steps of:
(a) providing selected amounts of powders of at least one noble or near-noble metal from Group VIII of the periodic table and at least one refractory metal selected from the group consisting of Groups IVB, VB, and VIB of the periodic table;
(b) mixing/blending the selected amounts of powders to form a mixed/blended powder having a selected atomic ratio of metals;
(c) forming the mixed/blended powder into a green compact having increased density;
(d) forming a full density compact from the green compact;
(e) cutting a target plate slice from the full density compact;
(f) diffusion bonding a backing plate to a surface of the target plate slice to form a target/backing plate assembly; and
(g) machining the target/backing plate assembly to a selected final dimension.

In accordance with embodiments of the present disclosure, step (a) comprises providing selected amounts of powders of at least one Group VIII metal selected from the group consisting of: ruthenium (Ru), rhodium (Rh), palladium (Pd), cobalt (Co), nickel (Ni), osmium (Os), iridium (Ir), and platinum (Pt); and at least one Group IVB, VB, or VIB refractory metal selected from the group consisting of tantalum (Ta), titanium (Ti), zirconium (Zr), hafnium (Hf), niobium (Nb), molybdenum (Mo), tungsten (W).

Preferably, step (a) comprises providing selected amounts of Ru and Ta powders; step (c) comprises cold isostatic pressing (CIP); step (d) comprises hot isostatic pressing (HIP); step (e) comprises electrical discharge machining (EDM); step (f) comprises HIP; and step (g) comprises machining the target/backing plate assembly to have a diameter of about 17.5 in.

Another aspect of the present disclosure is an improved sputtering target assembly fabricated according to the foregoing method.

Yet another aspect of the present disclosure is an improved method of fabricating a Ru-Ta alloy sputtering target assembly, comprising steps of:
(a) mixing/blending selected amounts of Ru and Ta powders to form a mixed/blended powder having a selected atomic ratio of Ru to Ta;
(b) forming the mixed/blended powder into a green compact having increased density;
(c) forming a full density compact from the green compact;
(d) cutting a target plate slice from the full density compact;
(e) diffusion bonding a backing plate to a surface of the target plate to form a target/backing plate assembly; and
(f) machining the target/backing plate assembly to a selected final dimension.

According to preferred embodiments of the present disclosure, step (a) comprises forming a mixed/blended Ru/Ta powder having an atomic ratio of Ru to Ta in the range from about 95 : 5 to about 5 : 95; step (b) comprises cold isostatic pressing (CIP); step (c) comprises hot isostatic pressing (HIP); step (d) comprises electrical discharge machining (EDM); and step (e) comprises HIP.

More preferably, step (a) comprises forming a mixed/blended Ru/Ta powder having an atomic ratio of Ru to Ta from about 90 : 10 to about 40 : 60; and step (e) comprises diffusion bonding a CuZn backing plate.

Further preferred embodiments of the present disclosure include those wherein step (f) comprises machining the target/backing plate assembly to have a diameter of about 17.5 in.

Other aspects of the present disclosure include improved Ru-Ta alloy sputtering target assemblies fabricated according to the above method.

Yet another aspect of the present disclosure is an improved metal alloy sputtering target assembly comprising:
(a) a target plate having a sputtering surface and comprised of at least one noble or near-noble metal from Group VIII of the periodic table and at least one refractory metal selected from the group consisting of Groups IVB, VB, and VIB of the periodic table; and
(b) a backing plate diffusion bonded to a surface of the target plate opposite the sputtering surface.

According to embodiments of the present disclosure, the target plate comprises at least one Group VIII metal selected from the group consisting of: ruthenium (Ru), rhodium (Rh), palladium (Pd), cobalt (Co), nickel (Ni), osmium (Os), iridium (Ir), and platinum (Pt); and at least one Group IVB, VB, or VIB refractory metal selected from the group consisting of tantalum (Ta), titanium (Ti), zirconium (Zr), hafnium (Hf), niobium (Nb), molybdenum (Mo), tungsten (W).

Preferably, the target plate comprises a Ru-Ta alloy having an atomic ratio of Ru to Ta in the range from about 95 : 5 to about 5 : 95, more preferably in the range from about 90 : 10 to about 40 : 60; the backing plate comprises CuZn; and the target has a diameter of about 17.5 in.

Additional advantages of the present disclosure will become readily apparent to those skilled in this art from the following detailed description, wherein only the preferred embodiments of the present disclosure are shown and described, simply by way of illustration of the best mode contemplated for practicing the present disclosure. As will be realized, the disclosure is capable of other and different embodiments, and its several details are capable of modification in various obvious respects, all without departing from the spirit of the present invention. Accordingly, the drawings and description are to be regarded as illustrative in nature, and not as restrictive.

### DETAILED DESCRIPTION OF THE DISCLOSURE

The present disclosure addresses and effectively solves, or at least mitigates, difficulties in fabricating sputtering targets comprising brittle metal alloys, particularly Ru and its alloys such as Ru-Ta, which brittle nature has heretofore impeded development of large diameter targets necessary for performing metallization processing of currently employed large diameter semiconductor wafers in a production-scale, cost-effective manner.

Briefly stated, according to the present disclosure, a special powder consolidation and diffusion bonding process is provided for fabricating sputtering targets comprising brittle metal alloys, such as Ru-Ta alloys, and involves cold as well as hot isostatic pressing, target slicing, target chemical etching, diffusion bonding, and final machining.

As utilized herein, the term "Group VIII metals", sometimes referred to as "Group VIIIB metals" is taken according to the old CAS periodic table classification notation, as for example, given in the Sargent-Welch Scientific Co. Periodic Table of the Elements, copyright 1968, and is intended to describe metal elements of Groups 8, 9, and 10 of the periodic table, excluding iron (Fe) but including ruthenium (Ru), rhodium (Rh), palladium (Pd), cobalt (Co), nickel (Ni), osmium (Os), iridium (Ir), and platinum (Pt); whereas the terms "Group IVB metals", "Group VB metals", and "Group VIB metals" (each also taken according to the old CAS periodic table classification notation) are intended to describe refractory metal elements including tantalum (Ta), titanium (Ti), zirconium (Zr), hafnium (Hf), niobium (Nb), molybdenum (Mo), tungsten (W), and combinations thereof

While the methodology described in the present disclosure is generally useful in the fabrication of all manner of targets comprised of an alloy of a Group VIII metal and a refractory metal from Groups IVB, VB, and VIB of the periodic table, the methodology described herein is especially useful in the fabrication of targets comprised of an alloy of Ru and Ta in view of the above described advantageous utility of such alloys in the manufacture of semiconductor integrated circuit devices utilizing Cu-based metallization. Targets of alloys contemplated by the present disclosure may also be utilized in the fabrication of data storage devices, e.g., magnetic disks, etc. Therefore, the following disclosure describing formation of Ru-Ta alloy sputtering targets is to be regarded as illustrative in nature, and not limitative.

In an initial step of an illustrative, but non-limitative, process according to the present disclosure for fabricating Ru-Ta alloy targets, fine powders of pure Ru and Ta having mesh sizes in the range from about 50 to about 500, preferably about 325, are intimately mixed/blended together, as by means of a Turbula blender or a V-blender. The relative amounts of the Ru-Ta powders determine the atomic ratio of Ru to Ta of the ultimately formed alloy, which may vary from about 95 : 5 to about 5 : 95, preferably from about 90 : 10 to about 40 : 60, most preferably about 50 : 50.

The mixture/blend of Ru and Ta powders is then subjected to cold isostatic pressing ("CIP") at a temperature between about 10 and about 80 °C, preferably about 25 °C, at a pressure from about 10 to about 60 ksi, preferably about 30 ksi, for from about 2 to about 60 mins., preferably about 20 mins., to form a green compact in plate form with an increased density from about 7 to about 12 g/cm³.

In a following step according to the present disclosure, the surfaces of the green plate are machined to remove any high spots or areas in order to reduce the likelihood of cracking during subsequent hot isostatic pressing ("HIP").

The machined Ru-Ta green plate is then canned utilizing a suitably structured can, e.g., a low carbon steel ("LCS") can, the interior walls of which are coated with a layer of a release agent, e.g., alumina (Al₂O₃). A rigid plate, e.g., of steel of sufficient thickness (e.g., about 1"), is positioned on each side of the green plate, the surfaces of each of the plates contacting the green plate also being coated with a layer of Al₂O₃ as a release agent. The latter serve to prevent cracking of the plate during HIP and maintain the Ru-Ta plate flat after HIP.

In the next step according to the present methodology, the canned assembly is subjected to HIP at a temperature between about 1000 and about 1600 °C, preferably about 1200 °C, at a pressure from about 10 to about 40 ksi, preferably about 30 ksi, for from about 1 to about 5 hrs., preferably about 2 hrs., to provide a Ru-Ta compact at substantially full density (~ 12.93 g/cm³) and with a grain size from about 5 to about 50 µm, preferably less than about 10 µm. According to an illustrative, but non-limitative, embodiment of the present disclosure, the Ru-Ta green plate is subjected to HIP for about 2 hrs. at a temperature in the range from about 1200 to about 1400 °C and a pressure of about 29 ksi.

The thus-densified Ru-Ta plate is then removed from the can and cut into slices from about 0.1 to about 1 in. thick, preferably about 0.25 in. thick, by means of a technique suitable for use with hard, brittle metal materials which cannot be machined using conventional techniques, e.g., electrical discharge machining ("EDM").

The surfaces of the Ru-Ta slice are then ground, e.g., with a numerical control-based hydraulic surface grinder to a surface finish with an Ra of ~ 32 µin. or better. The Ru-Ta slice and a suitable backing plate, e.g., a CuZn plate from about 0.5 to about 2 in. thick, are then machined in preparation for diffusion bonding, in order to provide mating surfaces with surface finish having an Ra of ~32 µin. or better, followed by chemical cleaning/etching treatment with acid and base solutions to remove any surface contamination, e.g., with nitric acid (HNO₃) and sodium hydroxide (NaOH) solutions.

Diffusion bonding of the Ru-Ta target slice and CuZn backing plate is accomplished by a canning process wherein an assembly of the target slice and backing plate, together with a pair of LCS plates, is placed in a LCS can coated with a suitable release agent, e.g., Al₂O₃. The function of the LCS plates is to prevent bowing and/or cracking of the Ru-Ta slice after diffusion bonding. The diffusion bonding process comprises performing HIP of the canned assembly at a temperature between about 600 and about 900 °C, preferably about 800 °C, at a pressure from about 10 to about 30 ksi, preferably about 15 ksi, for from about 1 to about 5 hrs., preferably about 2 hrs., to provide a diffusion bonded Ru-Ta/CuZn assembly wherein the shear stress between the Ru-Ta target and CuZn backing is from about 10 to about 20 ksi. According to an illustrative, but non-limitative, embodiment of the present disclosure, the assembly of Ru-Ta target slice and CuZn backing plate is subjected to HIP for about 2 hrs. at a temperature of about 800 °C and a pressure of about 15 ksi. The resultant shear stress between the target and backing layer is about 12 ksi. Following diffusion bonding, the target/backing plate assembly is removed from the can and machined to final dimensions.

In summary, advantages provided by the present methodology include the ability to fabricate diffusion bonded sputtering targets comprised of brittle metal alloys, for example, such as of Ru-Ta alloys, having very wide diameters, e.g., on the order of about 17.5 in., adapted for use in semiconductor related applications. Further, the present methodology is suitable for fabricating sputter targets comprised of a variety of brittle metal alloys useful in a number of applications, e.g., magnetic data storage media such as hard disks.

In the previous description, numerous specific details are set forth, such as specific materials, structures, reactants, processes, etc., in order to provide a better understanding of the present disclosure. However, the present disclosure can be practiced without resorting to the details specifically set forth. In other instances, well-known processing materials and techniques have not been described in detail in order not to unnecessarily obscure the present disclosure.

Only the preferred embodiments of the present disclosure and but a few examples of its versatility are shown and described in the present disclosure. It is to be understood that the present disclosure is capable of use in various other combinations and environments and is susceptible of changes and/or modifications within the scope of the disclosed concept as expressed herein.

## Claims

1. A method of fabricating a metal alloy sputtering target assembly, comprising steps of:
(a) providing selected amounts of powders of at least one noble or near-noble metal from Group VIII of the periodic table and at least one refractory metal selected from the group consisting of Groups IVB, VB, and VIB of the periodic table;
(b) mixing/blending said selected amounts of powders to form a mixed/blended powder having a selected atomic ratio of metals;
(c) forming said mixed/blended powder into a green compact having increased density;
(d) forming a full density compact from said green compact;
(e) cutting a target plate slice from said full density compact;
(f) diffusion bonding a backing plate to a surface of said target plate slice to form a target/backing plate assembly; and
(g) machining said target/backing plate assembly to a selected final dimension.

2. The method according to claim 1, wherein:
step (a) comprises providing selected amounts of powders of at least one Group VIII metal selected from the group consisting of: ruthenium (Ru), rhodium (Rh), palladium (Pd), cobalt (Co), nickel (Ni), osmium (Os), iridium (Ir), and platinum (Pt); and at least one Group IVB, VB, or VIB refractory metal selected from the group consisting of tantalum (Ta), titanium (Ti), zirconium (Zr), hafnium (Hf), niobium (Nb), molybdenum (Mo), tungsten (W).

3. The method according to claim 2, wherein:
step (a) comprises providing selected amounts of Ru and Ta powders.

4. The method according to claim 1, wherein:
step (c) comprises cold isostatic pressing (CIP).

5. The method according to claim 1, wherein:
step (d) comprises hot isostatic pressing (HIP).

6. The method according to claim 1, wherein:
step (e) comprises electrical discharge machining (EDM).

7. The method according to claim 1, wherein:
step (f) comprises HIP.

8. The method according to claim 1, wherein:
step (g) comprises machining said target/backing plate assembly to have a diameter of about 17.5 in.

9. A sputtering target assembly fabricated according to the method of claim 1.

10. A method of fabricating a Ru-Ta alloy sputtering target assembly, comprising steps of:
(a) mixing/blending selected amounts of Ru and Ta powders to form a mixed/blended powder having a selected atomic ratio ofRu to Ta;
(b) forming said mixed/blended powder into a green compact having increased density;
(c) forming a full density compact from said green compact;
(d) cutting a target plate slice from said full density compact;
(e) diffusion bonding a backing plate to a surface of said target plate slice to form a target/backing plate assembly; and
(f) machining said target/backing plate assembly to a selected final dimension.

11. The method according to claim 10, wherein:
step (a) comprises forming a mixed/blended Ru/Ta powder having an atomic ratio of Ru to Ta in the range from about 95 : 5 to about 5 : 95;
step (b) comprises cold isostatic pressing (CIP);
step (c) comprises hot isostatic pressing (HIP);
step (d) comprises electrical discharge machining (EDM); and
step (e) comprises HIP.

12. The method according to claim 11, wherein:
step (a) comprises forming a mixed/blended Ru/Ta powder having an atomic ratio of Ru to Ta from about 90 : 10 to about 40 : 60; and
step (e) comprises diffusion bonding a CuZn backing plate.

13. The method according to claim 11, wherein:
step (f) comprises machining said target/backing plate assembly to have a diameter of about 17.5 in.

14. A Ru-Ta alloy sputtering target assembly fabricated according to claim 11.

15. A Ru-Ta alloy sputtering target assembly fabricated according to claim 12.

16. A Ru-Ta alloy sputtering target assembly fabricated according to claim 13.

17. A metal alloy sputtering target assembly comprising:
(a) a target plate having a sputtering surface and comprised of at least one noble or near-noble metal from Group VIII of the periodic table and at least one refractory metal selected from the group consisting of Groups IVB, VB, and VIB of the periodic table; and
(b) a backing plate diffusion bonded to a surface of said target plate opposite said sputtering surface.

18. The target assembly as in claim 17, wherein:
said target plate comprises at least one Group VIII metal selected from the group consisting of: ruthenium (Ru), rhodium (Rh), palladium (Pd), cobalt (Co), nickel (Ni), osmium (Os), iridium (Ir), and platinum (Pt); and at least one Group IVB, VB, or VIB refractory metal selected from the group consisting of tantalum (Ta), titanium (Ti), zirconium (Zr), hafnium (Hf), niobium (Nb); molybdenum (Mo), tungsten (W).

19. The target assembly as in claim 18, wherein:
said target plate comprises a Ru-Ta alloy having an atomic ratio of Ru to Ta in the range from about 95 : 5 to about 5 : 95.

20. The target assembly as in claim 19, wherein:
said target plate comprises a Ru-Ta alloy having an atomic ratio of Ru to Ta in the range from about 90 : 10 to about 40 : 60.

21. The target assembly as in claim 19, wherein:
said backing plate comprises CuZn.

22. The target assembly as in claim 19, having a diameter of about 17.5 in.
